# EUROPÄISCHE PATENTSCHRIFT

(11) **EP 2 454 423 B1**
(45) Veröffentlichungstag und Bekanntmachung des Hinweises auf die Patenterteilung: **03.07.2013**
(21) Anmeldenummer: 09775750.4
(22) Anmeldetag: 17.07.2009
(51) Int. Cl.: E04C 2/22, E04C 2/26, E04C 2/288, E04C 2/52

(54) **WANDSTRUKTUR FÜR EIN GEBÄUDE**
WALL STRUCTURE FOR A BUILDING
STRUCTURE D'UNE MUR POUR DES BÂTIMENTS

(43) Veröffentlichungstag der Anmeldung: 23.05.2012
(73) Patentinhaber: Stone Treuhand AG, 8008 Zürich (CH)
(72) Erfinder: HILLERS, Guillaume Eugène, 8404 Stadel (CH)
(74) Vertreter: Rentsch Partner AG
(86) Internationale Anmeldenummer: PCT/CH2009/000257
(87) Internationale Veröffentlichungsnummer: WO 2011/006266

(56) Entgegenhaltungen:
- EP-A2- 0 191 144
- WO-A1-2005/121469
- WO-A1-2006/040623
- DE-U1-202004 012 893
- US-A- 5 491 945

## Beschreibung

Die vorliegende Erfindung betrifft das technische Gebiet der Gebäudekonstruktion und insbesondere eine Wandstruktur für ein Gebäude nach Anspruch 1, ein vorgefertigtes Bauelement mit dieser Struktur nach Anspruch 14 und ein Gebäude mit derart vorgefertigten Bauelementen nach Anspruch 15.

Aus der Patentschrift NL 8902670 ist bereits eine Gebäudestruktur mit einem Schaummaterial-Fundament und einer darauf errichtete Holzgerüst-Stützkonstruktion bekannt. Diese ist mit Frontpaneelen aus einem Schaummaterial verkleidet, die mit einem teilweise darin eingebetteten Metalldrahtgitter verstärkt sind.

Die internationale Patentanmeldung WO 2005/121469 zeigt eine Gebäudekomponente aus einem Schaummaterial, in das ein räumlich strukturiertes Verstärkungsnetz wenigstens teilweise eingebettet ist. Die von dem Schaummaterial abstehenden Netzteile werden zum Verankern einer Putzschicht genutzt.

Aus EP 0191144 ist ein plattenförmiger Baukörper zur Erstellung und Verkleidung von Mauern, Wänden und Fassaden bekannt. Der Baukörper umfasst wenigstens ein platten- oder wandartiges Gasbetonteil und eine Wärme-, Kälte- und Schallisolationsschicht, wobei beide Teile durch eine Klebschicht auf Zementbasis miteinander flächig verbunden sind und in die Klebschicht ein zähelastisches, metallfreies, korrosionsfestes Gewebe eingebettet ist. Mehrere solche plattenförmigen Baukörper können mittels Schrauben beidseitig auf einer Tragekonstruktion aus Holz bzw. Metall befestigt werden.

Es ist Aufgabe der vorliegenden Erfindung, die bekannten Wandstrukturen zu verbessern, insbesondere ihre Belastbarkeit, ihre Wärme -, Schall- und Strahlungsdämmung bei gleichzeitig einfachem konstruktivem Aufbau und leichter wie kostengünstiger Herstellbarkeit zu erhöhen.

Diese Aufgabe wird durch eine Wandstruktur für Gebäude nach Anspruch 1 gelöst.

Ein wesentlicher Punkt der Struktur besteht zunächst darin, dass deren üblicherweise geforderte Belastbarkeit allein durch den ersten Stützkörper in Verbindung mit dem darin wenigstens teilweise eingebetteten ersten Metalldrahtgitter gewährleistet ist. Das erste wellenförmige Gitter wirkt dabei derart stabilisierend, dass Spannungen, die durch auf den Stützkörper einwirkende statische oder dynamische Lasten entstehen, gleichmässig über diesen hinweg verteilt werden. Die erfindungsgemässe Struktur erweist sich deshalb auch als besonders erdbebenresistent, aber auch resistent gegen seitliche Krafteinwirkung. Durch das erste Gitter werden weiterhin Strahlungen vom Gebäudeinneren ferngehalten, wie sie z.B. von Hochspannungsleitungen, Telekommunikationsanlagen, radioaktiven Quellen o.Ä. ausgehen. Gleichzeitig dient das erste Gitter dazu, die Befestigungselemente sicher in ihrer Position zu halten, so dass diese nicht verrutschen und eine stabile Aufnahme der Isolationsschicht gewährleistet ist. Der Stützkörper kann aus einem Polyurethan-Schaum mit einer Kieseinlage bestehen, die hohe Druckresistenz, eine kapillare Wasserabsorption, eine unidirektionale Stabilität und eine gute Durchlässigkeit für Wasserdampf aufweist. Durch die gute Wärmeleitfähigkeit des ersten Gitters wird zudem verhindert, dass sich eine derart strukturierte Wand leicht aufheizt, da die aufgenommene Wärme über das Gitter abgeleitet wird. In Zusammenhang mit der Isolationsschicht entsteht damit eine besonders gute Wärme- und Schalldämmung z.B. gegen eine Verbindung aus heisser und zudem lauter Umgebung. Die beschriebene Wandstruktur ist ausserdem besonders einfach und kostengünstig herstellbar, z.B. durch vollautomatisierte Platzierung der Befestigungselemente an jeder gewünschten Stelle des Stützköpers, unabhängig z.B. von vorgegebenen Bohrlöchern.

Bevorzugte Weiterbildungen der erfindungsgemässen Wandstruktur sind in den Unteransprüchen angegeben. Diese betreffen insbesondere Dämmungs- und Stabilitätsaspekte sowie Ausstattungsdetails.

Erfindungsgemäss ist es vorgesehen, dass die Struktur eine Innenverkleidung aufweist, welche an eine zum Gebäudeinneren auszurichtende Oberfläche der Isolationsschicht angrenzt, und mit zweiten Befestigungselementen versehen ist, welche die Innenverkleidung durchgreifen, um diese an den Stützelementen zu befestigen. Die Stützelemente können damit nicht nur der Aufnahme der Isolationsschicht, sondern auch zur Befestigung der Innenverkleidung genutzt werden, und bilden damit ein einheitliches Befestigungssystem. Gleichzeitig stellt die Innenverkleidung eine weitere Isolationsschicht dar. Damit kann eine Wandstruktur mit bereits vormontierter Innenverkleidung geliefert werden, so dass eine diesbezügliche Montage auf der Baustelle (on site) entfällt.

Die Innenverkleidung umfasst einen zweiten plattenförmigen Stützkörper aus einem massiven Schaummaterial, der angrenzend zu der Isolationsschicht angeordnet ist. Damit erhöht sich die Belastbarkeit der Wandstruktur bei zudem steigender Wärme- und Schalldämmung erheblich. weiter umfasst die Innenverkleidung ein zweites wellenförmig ausgebildetes Metalldrahtgitter, das wenigstens teilweise in eine zum Gebäudeinneren auszurichtende Oberfläche des zweiten Stützkörpers eingeschäumt ist. Dadurch verstärken sich die Vorteile, die schon im Zusammenhang mit dem ersten Metalldrahtgitter genannt wurden. Insbesondere verhindert auch das zweite Gitter, dass sich die Wand aufwärmt, so dass eine gute Wärmedämmung gegen eine kalte Umgebung entsteht. Es ist dabei denkbar, die Schichtung der erfindungsgemässen Wandstruktur anforderungsabhängig beliebig zu wiederholen, d. h. auf den zweiten Stützkörper (mit zweitem Gitter) wiederum eine Isolationsschicht folgen zu lassen und auf diese wiederum einen dritten Stützkörper (mit drittem Gitter) usw..

Bevorzugt weist eine solche Innenverkleidung eine Innenputzschicht auf, die auf der zum Gebäudeinneren auszurichtenden Oberfläche des zweiten Stützkörpers aufgebracht und an dem zweiten Metalldrahtgitter verankert ist. Über das zweite Gitter ist damit ein besonders sicherer Halt der Innenputzschicht an dem zweiten Stützkörper gewährleistet. Durch die besonders gute Spannungsverteilung in den zweiten Stützkörper eingeleiteter Lasten wird ausserdem eine Rissbildung im Putz sicher ausgeschlossen.

Bei Anbringung einer Innenverkleidung ist es weiterhin bevorzugt, eine dampfdurchlässige Folie anzubringen, die sich zwischen der Isolationsschicht und der Innenverkleidung erstreckt. Damit wird Schwitzwasser, dass sich zwangsläufig bei Temperaturwechseln in der Isolationsschicht bildet, aus diesem Raum entweichen kann. Damit ist eine Durchfeuchtung der Wand von innen her ausgeschlossen.

Ähnlich der Innenverkleidung kann auch eine Aussenverkleidung vorgesehen sein, die an eine zum Gebäudeäusseren auszurichtende Oberfläche der ersten Stützschicht angrenzt, und die eine Aussenputzschicht umfasst, welche an dem ersten Metalldrahtgitter verankert ist. Eine solche Aussenputzschicht bedeckt dabei vollständig das erste wellenförmige Metalldrahtgitter und verhindert ebenfalls ein Aufheizen der Wandstruktur. Zudem wirkt der Aussenputz feuchtigkeitsabweisend und ist zudem frost- und schockresistent. Grundsätzlich kann die Aussenverkleidung aber auch aus einer Mörtelschicht bestehen, welche das erste Gitter bedeckt, und die wiederum Zierplatten trägt.

Wandstrukturen, die höchsten Belastungen ausgesetzt sind, weisen bevorzugt ein jeweiliges dreidimensionales Metalldrahtgitter auf, das vollständig in den ersten und/oder zweiten Stützkörper eingeschäumt ist. Damit wird die Belastungsfähigkeit der Wandstruktur noch einmal deutlich erhöht. Die Isolationsschicht besteht in bevorzugter Weise aus einem Mineralwollmaterial, das die einfachste und wirksamste Wärme- und Schalldämmung darstellt, die noch dazu kostengünstig ist.

Eine besonders leicht zu montierende und haltbare Befestigung der Stützelemente ergibt sich, wenn die ersten und/oder zweiten Befestigungselemente aus einer jeweiligen Schrauben - und Widerlagerkombination bestehen. Das Widerlager kann im einfachsten Fall aus einer Gewindemutter bestehen, die gegen einen Teil des Stützelements angezogen wird und so das Element in Position hält. Denkbar sind aber auch platten - oder blockförmige Lager mit darin angebrachten Gewindelöchern, die eine möglichst grosse Fixierungsfläche zulassen.

Noch einfacher zu montieren ist allerdings eine jeweilige Schrauben- und Widerlagerkombination, die eine selbstschneidende Schraube und ein Widerlager aus einem Kunststoffmaterial umfasst. Dabei entfällt eine genaue Ausrichtung beider Teile auseinander, insbesondere dann, wenn das Widerlager platten- oder blockförmig ausgeprägt ist.

Um eine besonders stabile Befestigung der Stützelemente zu erzielen, ist der Kopfdurchmesser einer jeweiligen Schraube bevorzugt grösser als die Maschenweite des ersten bzw. zweiten Metalldrahtgitters gewählt. Die Schraube kann damit zum einen gegen das Gitter angezogen und zugleich in seinen Maschen gehalten werden.

Grundsätzlich kann für eine jeweilige Schraube eine Unterlegscheibe vorgesehen sein, deren Durchmesser grösser als die Maschenweite des ersten bzw. zweiten Metalldrahtgitters ist. Dadurch kann ein und dieselbe Schraube in Metalldrahtgittern unterschiedlich grosser Maschenweite Verwendung finden, wenn nur die Unterlegscheibe entsprechend angepasst wird.

Um auszuschliessen, dass die Schrauben- und Widerlagerkombination als Wärme- oder Kältebrücke wirkt, kann die Schraube grundsätzlich aus einem nur schlecht wärmeleitfähigen Material hergestellt sein. Um aber auch besonders hochbelastbare Schrauben aus einem Metallmaterial einsetzen zu können, ist der Kopf einer jeweiligen Schraube bevorzugt mit einer Kunststoffkappe abdeckbar und/oder die Unterlegscheibe besteht aus einem Kunststoff. Damit ist der Schraubenkopf gegenüber seiner unmittelbaren Umgebung vollständig verkapselt und somit wärmeisoliert.

Grundsätzlich kann das Stützelement auch selbst aus einem Holz- oder Kunststoffmaterial ausgeführt sein, womit eine darin eingedrehte - selbstschneidende - Schraube auch auf Seiten ihres Widerlagers wärmeisoliert wäre. Besteht das Stützelement aber aus einem metallischen Werkstoff ist es bevorzugt, wenn eine jeweilige Stützelement- und Widerlagerkombination so geformt und bemessen sein, dass eine in das Widerlager eingedrehte Schraube nicht mit dem Stützelement in Kontakt tritt.

Eine besonders einfache Montage der Stützelement- und Widerlagerkombination ist dabei dann gegeben, wenn diese so geformt und bemessen ist, dass beim Eindrehen der Schraube eine Bewegung des Widerlagers gegenüber dem Stützelement blockiert ist. Das Widerlager wird somit passgenau von dem Stützelement aufgenommen, was weitere Verbindungselemente oder -Materialien zwischen beiden überflüssig macht.

Bevorzugt weist dazu ein jeweiliges Stützelement eine im Wesentlichen U-förmige Querschnittsform auf, deren Schenkel mit Durchtrittsöffnungen zur Aufnahme der Befestigungselemente versehen sind. Ein derart geformtes Stützelement hat den Vorteil, dass dessen Basis als Anschlag für ein entsprechend geformtes Widerlager dienen kann.

Unabhängig von der Form der Stützelemente können diese bevorzugt genutzt werden, um in der Wandstruktur elektrische Leitungen unterzubringen, die in der Isolationsschicht verlaufen und von den Stützelementen gehalten sind.

In einer weiteren bevorzugten Ausführungsform ist die erfindungsgemässe Wandstruktur mit Heiz- und/oder Kühlschläuchen versehen, die in der Innen- und/oder Aussenverkleidung verlegt sind und im Wesentlichen zwischen den Wellenbergen des ersten und/oder zweiten Metalldrahtgitters verlaufen, welche über die jeweilige Oberfläche des ersten und/oder zweiten Stützkörpers hinausragen. Dadurch werden die Schläuche einerseits zwischen den Wellenbergen geführt und können einfach verlegt werden. Gleichzeitig können die Schläuche auch leicht an dem ersten bzw. zweiten Gitter befestigt werden, z.B. mittels an sich bekannten Kabelbindern.

Eine noch einfachere Befestigung entsteht dann, wenn die Heiz- und/oder Kühlschläuche zwischen einem jeweils zusätzlichen, sich über die Wellenberge der ersten und/oder zweiten Metalldrahtgitter hinweg erstreckenden, ebenen Metalldrahtgitter und dem ersten und/oder zweiten wellenförmigen Metalldrahtgitter gehalten sind. Damit werden die Schläuche flächig abgedeckt und zwischen den Wellenbergen des ersten bzw. zweiten Gitters fixiert, was einfacher zu bewerkstelligen ist.

Alternativ dazu können die Heiz- und/oder Kühlschläuche auch in einem jeweils zusätzlichen dreidimensionalen Metalldrahtgitter gehalten sein, das sich über die Wellenberge der ersten und/oder zweiten Metalldrahtgitter hinweg erstreckt. Sowohl das erste bzw. zweite als auch das zusätzliche Gitter werden z.B. in einer Putz- oder Mörtelschicht aufgenommen, die dadurch an Stabilität bzw. Tragfähigkeit gewinnt. Die Schläuche können dabei schon in dem zusätzlichen Gitter verlegt sein, bevor dieses Gitter angebracht wird. Dadurch wird die Montage der Heiz- und/oder Kühlschläuche deutlich erleichtert und beschleunigt.

Eine besonders gute Tragfähigkeit, Dämm- und Strahlungsschutzwirkung des ersten und zweiten Metalldrahtgitters wird erzielt, wenn deren Maschenweite zwischen 5 mm und 30 mm liegt, bevorzugt ungefähr 10 mm beträgt.

In bevorzugter Weise sollen vorgefertigte Bauelemente für ein Gebäude, insbesondere Wand-, Boden- oder Deckenelemente, die erfindungsgemässe Wandstruktur aufweisen. Diese Elemente können entsprechend der vorstehend beschriebenen Ausführungsformen konfiguriert werden, so dass sich weitere Montagevorgänge 'on site' erübrigen. Damit ist eine besonders schnelle Erstellung von Gebäuden in unterschiedlichen, dem Kundenwunsch gemässen Varianten möglich.

Gebäude mit diesen vorgefertigten Bauelementen werden bevorzugt so gestaltet, dass die Bauelemente so angeordnet und miteinander verbunden sind, dass deren erste und/oder zweite Metalldrahtgitter einen Faradayschen Käfig bilden. Damit ist ein idealer Strahlungsschutz gegenüber dem Gebäudeäusseren, z.B. gegen Telekommunikationsstrahlung, Hochspannungsfelder, radioaktive Strahlung o. Ä. sichergestellt.

Ausführungsbeispiele der Erfindung werden im Folgenden unter Bezugnahme auf die beigelegten Figuren detailliert erläutert. Massangaben in den Zeichnungen stellen Angaben in Millimetern [mm] dar. Gleiche oder gleichwirkende Teile sind mit gleichen Bezugsziffern versehen. Es zeigen:
- Figur 1: eine Querschnittsansicht einer Wandstruktur zur Verdeutlichung ihres grundlegenden Aufbaus;
- Figur 2A: eine Querschnittsansicht einer Wandstruktur mit Innenverkleidung;
- Figur 2B: eine räumliche Darstellung der Wandstruktur der Figur 2A;
- Figur 3A: eine Querschnittsansicht einer erfindungsgemässen Wandstruktur mit Innenverkleidung;
- Figur 3B: eine räumliche Darstellung der Wandstruktur der Figur 3A;
- Figur 4A: eine räumliche Darstellung eines zusätzlichen dreidimensionalen Metalldrahtgitters zur Aufnahme von Heiz- und/oder Kühlschläuchen;
- Figur 4B: eine räumliche Darstellung eines ersten bzw. zweiten wellenförmigen Metalldrahtgitters zur Einbettung in erste bzw. zweite Stützkörper;
- Figur 5A: eine Seitenansicht eines ersten bzw. zweiten Stützkörpers mit den Gittern der Figuren 4;
- Figur 5B: eine Vorderansicht des ersten bzw. zweiten Stützkörpers nach Figur 5A, und
- Figur 6: eine Draufsicht auf die Gitter der Figuren 5.

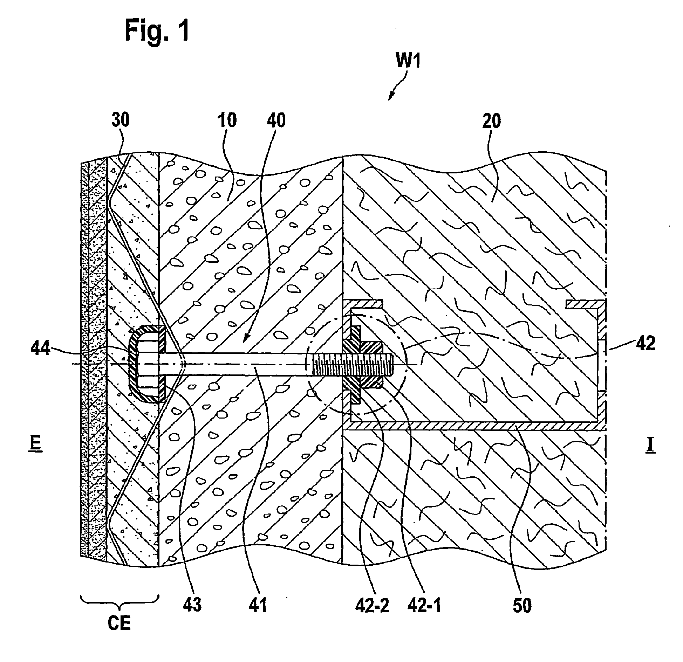

Die Figur 1 zeigt eine Querschnittsansicht einer Wandstruktur W1 (Wall 1) zur Verdeutlichung ihres grundlegenden Aufbaus. Eine Grundstruktur umfasst dabei einen ersten Stützkörper 10 aus einem Polyurethan-Schaum mit einer Kieseinlage, an dessen zum Gebäudeinneren I (Interior) gerichteten Oberfläche eine Isolationsschicht 20 aus Mineralwolle anliegt. Ein erstes wellenförmiges Metalldrahtgitter 30 ist in die zum Gebäudeäusseren E (Exterior) gerichteten Oberfläche des ersten Stützkörpers 10 eingeschäumt, so dass dessen Wellenberge davon abstehen. Erster Stützkörper 10 und erstes wellenförmiges Gitter 30 stellen tragende Elemente der Struktur W1 dar. Durch den Stützkörper 10 hindurch erstrecken sich Befestigungselemente 40, die im Wesentlichen U-förmige Stützelemente 50 aus einem Stahl halten, zwischen denen die Isolationsschicht 20 aufgenommen und damit am Stützkörper 10 gehalten ist. Beispielhaft ist hier ein Befestigungselement 40 gezeigt, das aus einer (Schaft)Schrauben- und Widerlagerkombination 41, 42 besteht.

Das Widerlager 42 umfasst dabei eine Mutter 42-1, die gegen eine Kunststoffbuchse 42-2 angezogen wird, welche wiederum formschlüssig in dem U-förmigen Stützelement 50 aufgenommen ist. Damit wird eine Isolation des Befestigungselements 40 erzielt, die einen Wärmeübergang zwischen Stützelement 50 und Schraube 41 (oder umgekehrt) verhindert. Um die Isolationswirkung der Schrauben- und Widerlagerkombination 41, 42 noch zu erhöhen, besteht die Schraube 41 zusätzlich aus einem schlecht wärmeleitenden, aber dennoch ausreichend zugfesten Kunststoffmaterial. Zum Gebäudeäusseren ist deren Schraubenkopf zudem mit einer Abdeckung 44 und einer Unterlegscheibe 43 aus Kunststoff versehen, um auch dort den isolierenden Effekt zu erhalten. Die Unterlegscheibe 43 weist dabei einen Durchmesser auf, der grösser als die Maschenweite des ersten Gitters 30 ist, so dass das Gitter der Anzugskraft der Schraube 41 entgegen wirkt und diese gleichzeitig in Position hält. Die zum Gebäudeäusseren gerichtete Oberfläche des ersten Stützkörpers 10 ist mit einer Aussenverkleidung CE (Cover Exterior) versehen, die unterschiedliche Schichten Mörtel und eine Verklinkerung (nicht näher bezeichnet) umfasst.

Das erste wellenförmige Metalldrahtgitter 30 greift dabei in die Aussenverkleidung CE ein und hält diese, so dass deren Tragfähigkeit erheblich erhöht wird. Gleichzeitig dient es zur Verstärkung des Stützkörpers 10 und zur flächigen Spannungsverteilung in diesem Körper 10. Dies führt zum einen zu einer deutlich erhöhten Tragfähigkeit der Wandstruktur W1 und verhindert zum anderen eine Rissbildung in Stützkörper 10 und Aussenverkleidung CE. Dadurch ist die Wandstruktur W1 gegen statische wie auch dynamische Beanspruchung, und zwar sowohl in vertikaler wie auch horizontaler Richtung besonders resistent. Das erste Gitter 30 wirkt zudem als Wärmedämmung, da es Wärme ableitet und so eine Aufheizung der Struktur W1 verhindert. Ausserdem stellt es einen wirksamen Schutz gegen alle Arten von elektromagnetischen Feldern dar. Der konstruktive Ausschluss einer Wärmebrücke am Befestigungselement 40 in Verbindung mit dem ersten Stützkörper 10 aus Schaumstoff und der Isolationsschicht 20 aus Mineralwolle sorgt weiterhin für eine optimale Wärme- und Schalldämmung der Struktur W1. Der Stützkörper 10 kann noch mit einem vollständig darin eingeschäumten, zusätzlichen dreidimensionalen Metalldrahtgitter versehen sein, dass dessen Belastungsfähigkeit noch weiter erhöht.

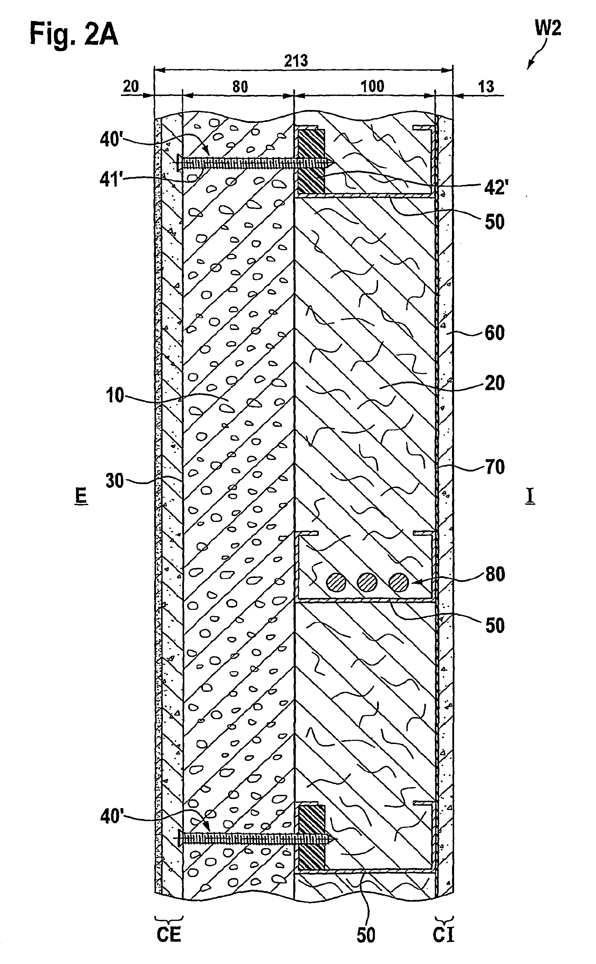

Die Figur 2A zeigt eine Querschnittsansicht einer Wandstruktur W2 mit Innenverkleidung CI (Cover Interior), die vom Grundaufbau der bereits in Figur 1 gezeigten Wandstruktur W1 ausgeht. Die Innenverkleidung CI besteht beispielhaft aus Gipskartonplatten 60, welche die Isolationsschicht 20 vollständig abdecken und über hier nicht gezeigte Befestigungselemente mit den U-förmigen Stützelementen 50 verbunden sind. Die Stützelemente 50 dienen damit der Aufnahme der Isolationsschicht 20 und der Halterung der Innenverkleidung 60. Im Unterschied zur Wandstruktur W1 der Figur 1 werden die Stützelemente 50 von Befestigungselementen 40' gehalten, die aus einer Schrauben - und Widerlagerkombination 41', 42' bestehen. Die Schraube 41' ist dabei mit einem selbstschneidenden Gewinde ausgestattet, welches in das Widerlager 42' aus einem Kunststoff- oder auch Holzmaterial eingedreht wird. Das Widerlager 42' ist formschlüssig und damit gegen Verdrehung blockiert in einem Schenkel des U-förmigen Stützelements 50 aufgenommen, der dazu das Widerlager 42' an seiner Oberseite noch einmal umgreift. Insgesamt lässt eine solche Ausführung der Befestigungselemente 40' die besonders einfache und vollautomatisierbare Montage der Wandstruktur W2 zu. Zwischen Innenverkleidung CI und Isolationsschicht 20 ist dabei eine dampfdurchlässige Folie 70 aus einem PVC-Material angebracht, um eine Belüftung der innenliegenden Isolationsschicht 20 bei gleichzeitiger Verhinderung eines Flüssigkeitsdurchtritts zu gewährleisten. Da sich die Innenverkleidung CI bereits vormontieren lässt, ist deren Anbringung on site' nicht mehr erforderlich. Kundenwünsche können zudem bereits in einer sehr frühen Gebäudeerstellungsphase Berücksichtigung finden. Die Aussenverkleidung CE der hier gezeigten Wandstruktur W2 soll prinzipiell nicht anders sein als diejenige der Figur 1. Insgesamt ist die Struktur W2 damit besonders belastbar, ohne die anderen in Bezug auf Figur 1 schon geschilderten Vorteile vermissen zu lassen. In der Wandstruktur W2 sind darüber hinaus noch elektrische Leitungen 80 verlegt, die in der Isolationsschicht 20 verlaufen und in den U-förmigen Stützelementen 50 gehalten werden. Damit ist auch eine elektrische Verkabelung in der Wandstruktur vorkonfektionierbar, die 'on site' lediglich noch verschaltet werden muss.

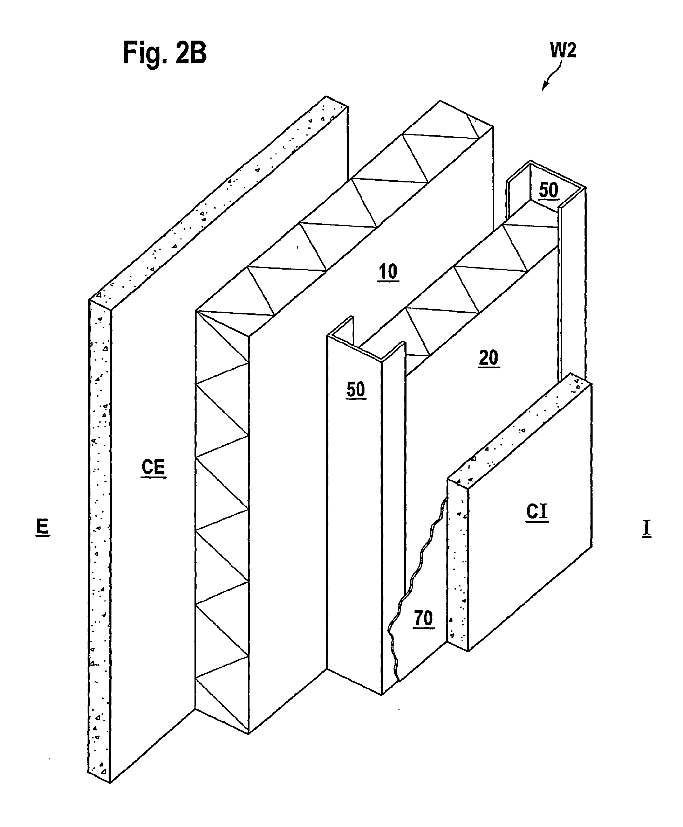

Die Figur 2B zeigt eine räumliche Darstellung der Wandstruktur der Figur 2A. Zwischen der Innen- und Aussenverkleidung CI und CE der Struktur W2 ist der erste Stützkörper 10 zu erkennen, an den die Isolationsschicht 20 angrenzt. Die räumliche Ausführung der Stützelemente 50 zeigt, dass diese als langgestreckte U-förmige Bleche ausgeführt sind. Die Öffnungen der Stützelemente 50 sind im dargestellten Abschnitt der Struktur W2 einander so zugewandt, dass die Isolationsschicht 20 zwischen diesen gehalten wird. Zwischen der Innenverkleidung CI und der Isolationsschicht 20 erstreckt sich eine PVC-Folie 70, die durchlässig für Gase und Wasserdämpfe ist und dem Wasserdurchgang in Flüssigkeitsform widersteht. Aus Übersichtlichkeitsgründen sind die Befestigungselemente 40 und das in dem ersten Stützkörper 10 eingebettete erste wellenförmige Metalldrahtgitter 30 nicht dargestellt. Die räumliche Darstellung der Struktur W2 verdeutlicht den einfachen und kompakten Aufbau der Gebäudewand, der extrem tragfähig und robust und gleichzeitig strahlungsundurchlässig sowie wärme- und schalldämmend ist. Eine entsprechende Wand kann zudem wunschgemäss konfiguriert, vollautomatisiert hergestellt und 'on site' verbaut werden.

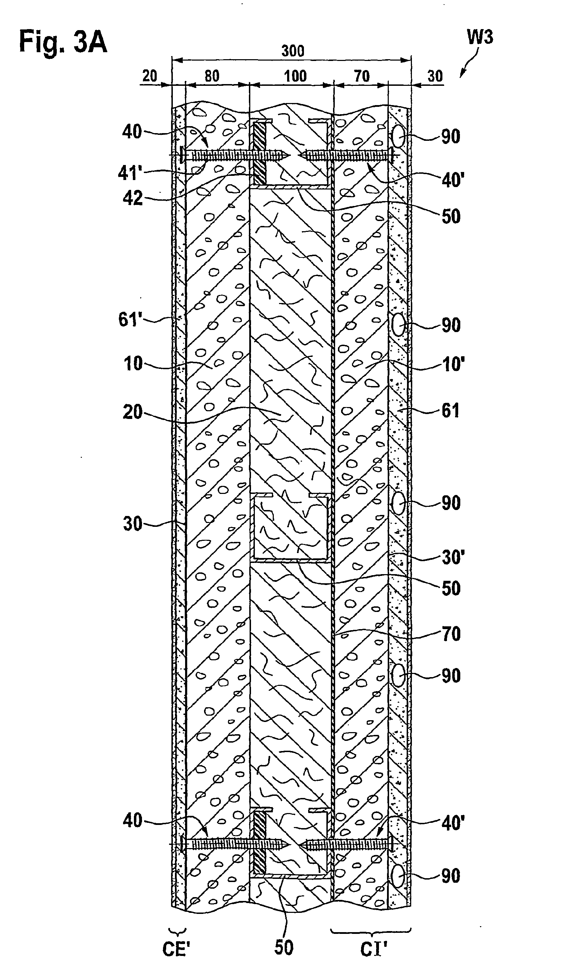

Die Figur 3A zeigt eine Querschnittsansicht einer dritten erfindungsgemässen Wandstruktur W3 mit Innenverkleidung CI'. Die Struktur W3 geht dabei von dem schon in Figur 2 beschriebenen Grundaufbau der Wandstruktur W2 aus. Die Stützelemente 50 werden auch hier über Befestigungselemente 40 gehalten, die eine selbstschneidende Schraube 41' umfassen, die in ein Widerlager 42' aus einem Kunststoff- oder auch Holzmaterial eingedreht wird. Die Aussenverkleidung CE' der Struktur W3 weist hier eine Aussenputzschicht 61' auf, die an dem ersten wellenförmigen Metalldrahtgitter 30 verankert ist. Die Struktur W3 unterschiedet sich weiterhin durch ihre Innenverkleidung CI', die einen zweiten Stützkörper 10'und eine Innenputzschicht 61' umfasst, in der Heiz- und/oder Kühlschläuche 90 zum Heizen bzw. Kühlen des Gebäudeinneren I verlegt sind. Der zweite Stützkörper 10' ist spiegelbildlich zum ersten Stützkörper 10 mit einem zweiten wellenförmigen Metalldrahtgitter 30' ausgestattet, das ebenfalls wenigstens teilweise in diesen eingebettet ist. Ebenfalls spiegelbildlich zum ersten Stützkörper 10 wird der zweite Stützkörper 10' über Befestigungselemente 40' mit selbstschneidenden Schrauben an den Stützelementen 50 befestigt. Das zweite wellenförmige Gitter 30' erfüllt dabei wie beim ersten Stützkörper 10 zum einen die Aufgabe, die Befestigungselemente 40' zu stabilisieren, d.h. zu stützen und in Position zu halten. Zum anderen aber dient es hier zusätzlich der Führung und Befestigung der Heiz - und/oder Kühlschläuche 90 zwischen den Wellenbergen des abstehenden Gitters 30'. Damit ist eine besonders einfache Verlegung und Befestigung dieser Schläuche 90 am zweiten Stützkörper möglich, bevor der Innenputz 61 aufgebracht wird. Grundsätzlich ist es natürlich zusätzlich oder alternativ möglich, in an sich ähnlicher Art und Weise Heiz - und/oder Kühlschläuche im Aussenputz 61' anzubringen. Zwischen Innenverkleidung CI' und Isolationsschicht 20 ist wiederum eine dampfdurchlässige Folie 70 angebracht. In der Isolationsschicht 20 können natürlich auch hier elektrische Leitungen verlegt sein, was hier aus Übersichtlichkeitsgründen aber nicht dargestellt ist. Auf Grund der Innenverkleidung CI' mit zweitem Stützkörper 10' weist die dargestellte Wandstruktur W3 eine gesteigerte Tragfähigkeit und Stabilität auf, die aber grundsätzlich auch noch durch Einschäumen von dreidimensionalen Metalldrahtgittern in die Stützkörper 10, 10' erhöht werden könnte. Gleichzeitig wird die Wärme- und Schalldämmung der Struktur W3 erhöht, und durch die Dopplung der wellenförmigen Gitter 30, 30' ein erhöhter Strahlungsschutz erreicht.

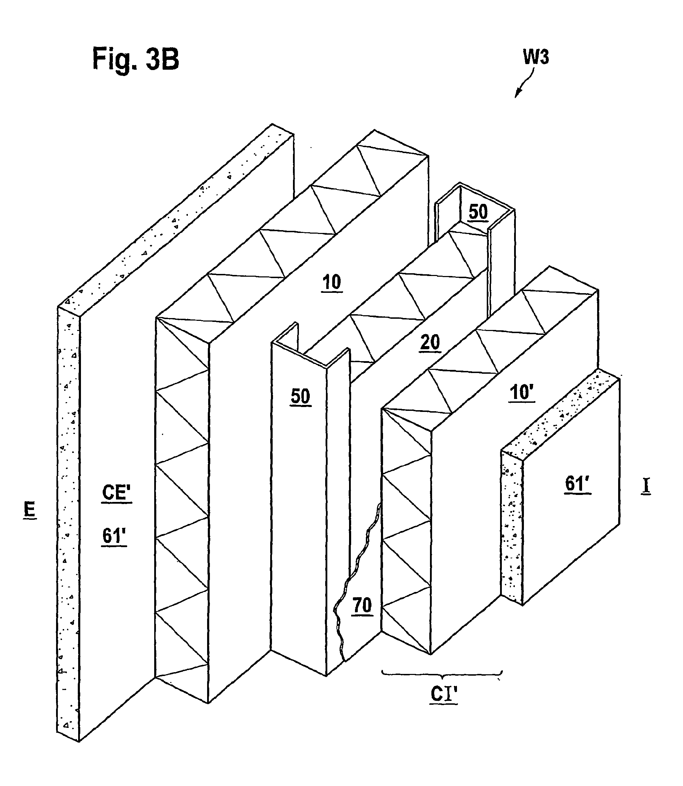

Die Figur 3B zeigt eine räumliche Darstellung der Wandstruktur W3 der Figur 3A. Aus dieser ist noch einmal der Grundaufbau der erfindungsgemässen Struktur ersichtlich, der zwischen der Aussen- und Innenverkleidung CE', CI' aufgenommen ist. Die Innenverkleidung CI' umfasst dabei den zweiten Stützkörper 10' und eine Innenputzschicht 61. Zwischen Innenverkleidung CI' und Isolationsschicht 20 ist die dampfdurchlässige Folie 70 angebracht. Auch die räumliche Darstellung der Struktur W3 verdeutlicht den einfachen und kompakten Aufbau einer erfindungsgemässen Gebäudewand, der extrem tragfähig und robust, gleichzeitig strahlungsundurchlässig sowie wärme- und schalldämmend ist. Eine diese Wand kann wunschgemäss konfiguriert, vollautomatisiert hergestellt und 'on site' verbaut werden.

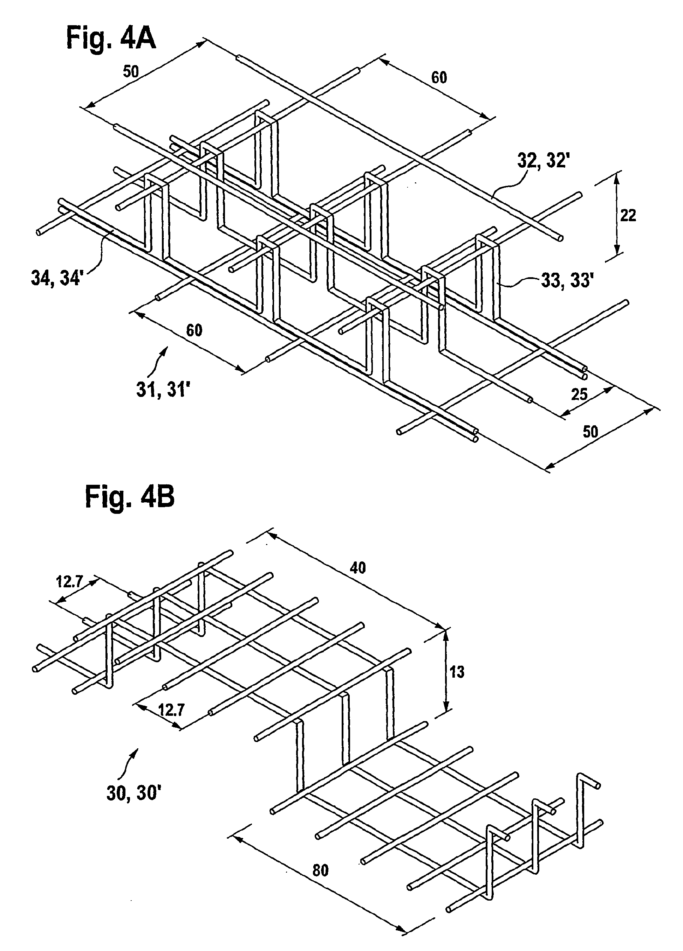

Die Figur 4A zeigt eine räumliche Darstellung eines zusätzlichen dreidimensionalen Metalldrahtgitters 31, 31' zur Aufnahme von Heiz- und/oder Kühlschläuchen 90. Das Gitter 31, 31' besteht aus zwei ebenen Gittern 32, 32' und 34, 34', zwischen denen ein dreidimensionales wellenförmiges Gitter 33, 33'angebracht ist. Die dadurch entstehende, äusserst stabile Konstruktion kann in eine Innen- und/oder Aussenverkleidung CI', CE' der erfindungsgemässen Wandstruktur eingebettet werden und zu deren zusätzlicher Stabilisierung dienen. Insbesondere können aber auch Heiz- und/oder Kühlschläuche in den Kanälen der Gitter 31, 31' aufgenommen sein, und zwar schon vor Anbringung des Gitters 31, 31' in den Verkleidungen CI', CE'. Damit wird eine besonders einfache Verlegung der Schläuche möglich.

Die Figur 4B zeigt eine räumliche Darstellung eines ersten bzw. zweiten wellenförmigen Metalldrahtgitters 30, 30' zur Einbettung in erste bzw. zweite Stützkörper 10, 10'. Das Wellental der Gitter 30, 30' ist dabei in die Oberfläche der Stützkörper 10, 10' eingeschäumt, während die Wellenberge davon abstehen und eine aufzubringende Putz- oder Mörtelschicht eingreifen. Die Maschenweite der Gitter beträgt hier 12,7 mm.

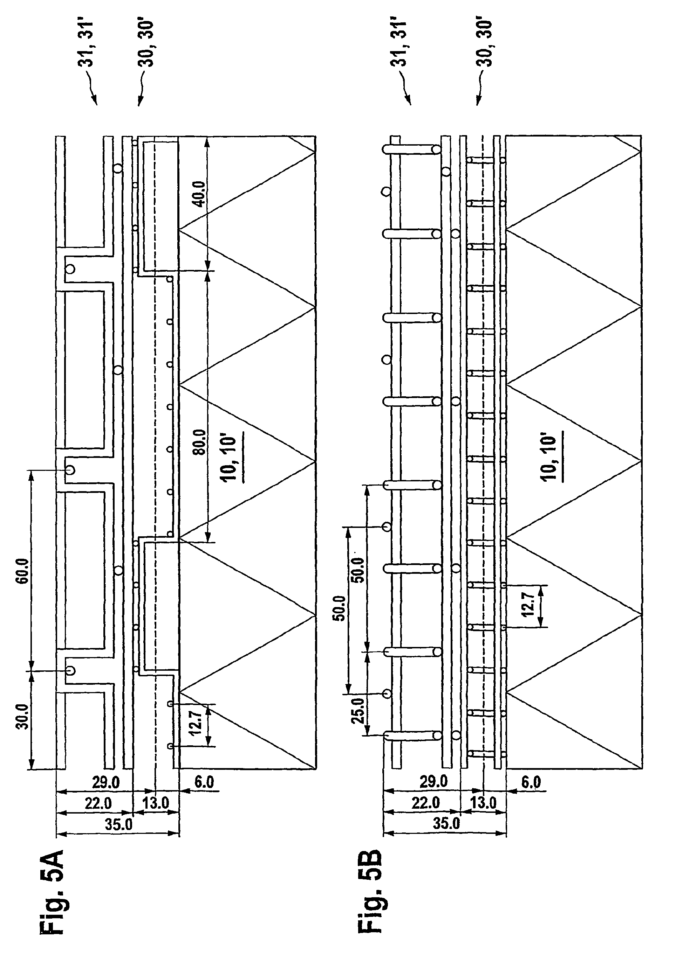

Die Figur 5A zeigt eine Seitenansicht eines ersten bzw. zweiten Stützkörpers 10, 10' mit den Gittern 30, 30' und 31, 31' der Figuren 4. Die Gitter 30, 30' werden in einer Tiefe von 6 mm in die Stützkörper 10, 10' eingeschäumt und an ihrer Oberseite mit dem dreidimensionalen Gitter 31, 31' verbunden. In den Kanälen des Gitters 31, 31' können Heiz - und/oder Kühlschläuche verlegt sein, bevor die Gitter 31, 31' in eine Verkleidung eingebettet werden. Bei entsprechender Bemessung der Gitter 30, 30' ist aber auch eine Verlegung der Schläuche zwischen den Wellenbergen der Gitter 30, 30' und deren Halterung durch die Gitter 31, 31' denkbar, welche über die Wellenberge hinweg geführt sind.

Die Figur 5B zeigt eine Vorderansicht des ersten bzw. zweiten Stützkörpers 10, 10' der Figur 5A. Dabei wird ersichtlich, dass die Heiz- und/oder Kühlschläuche auch in einer senkrecht zu den Kanälen der Figur 5A verlaufenden Richtung verlegbar sind, so dass sich eine durchgängig gute Halterung der Schläuche in allen Richtungen ergibt.

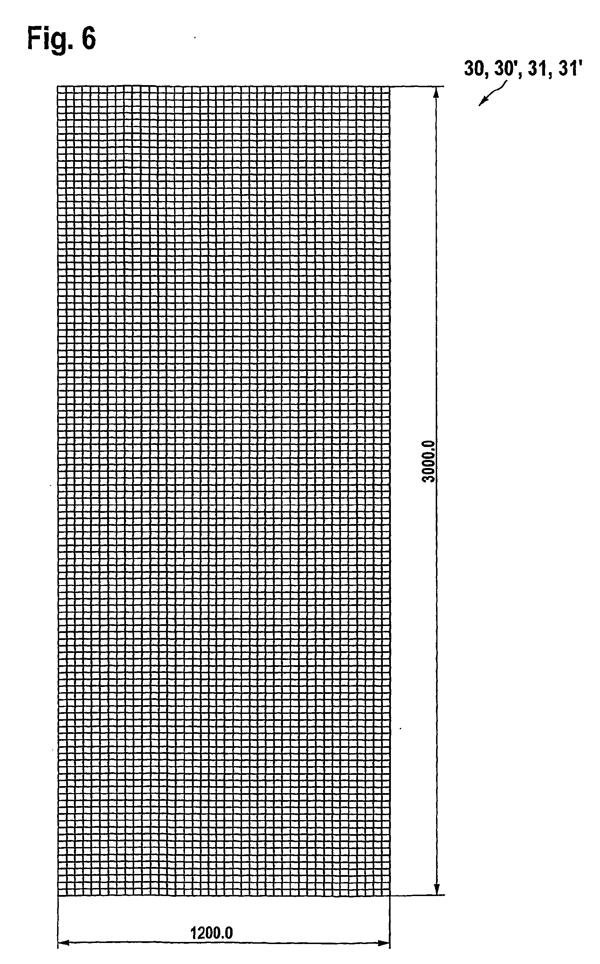

Die Figur 6 zeigt eine Draufsicht auf die Gitter 30, 30' und 31, 31' der Figuren 5, aus der sich die durchgängig gleiche Maschenweite der gemeinsamen Gitterstruktur ergibt. Diese erfordert nur ein durchgängig gleiches Befestigungselement, welches die Gitter 30, 30' (oder zusätzlich die Gitter 31, 31') und die Stützkörper 10, 10' durchtritt, um die Stützelemente am Stützkörper 10, 10' zu befestigen. Die Figur veranschaulicht auch, dass eine solche Gitterstruktur besonders gut geeignet ist, in gleichem Mass stabilisierend und wärmeableitend zu wirken sowie unerwünschte elektromagnetische Strahlung zu blockieren. Insbesondere lassen sich Wandelemente mit der erfindungsgemässen Struktur so miteinander verbinden, dass ein Faradayscher Käfig entsteht, der ein Gebäudeinneres vor Strahlung, Blitzschlag o. Ä. schützt.

Grundsätzlich ist natürlich denkbar, zur weiteren Verbesserung der Leistungsfähigkeit der erfindungsgemässen Wandstruktur eine mehrfache Schichtung ihres Grundaufbaus, also eine mehrfache Aneinanderreihung von Stützkörpern mit Metalldrahtgittern sowie Isolierungsschichten vorzunehmen, die jeweils über Befestigungselemente miteinander verbunden sind. Entsprechende Schichtungen sind abhängig von den spezifischen Anforderungen an eine Wandstruktur für Gebäude und liegen im Ermessen des Fachmanns.

## Patentansprüche

1. Wandstruktur (W1; W2; W3) eines Gebäudes, mit einem ersten plattenförmigen Stützkörper (10) aus einem massiven Schaummaterial, dessen zum Gebäudeinneren (I) auszurichtende Oberfläche an eine Isolationsschicht (20) angrenzt, und mit ersten Befestigungselementen (40), die den ersten Stützkörper (10) durchgreifen, um Stützelemente (50) zu befestigen, zwischen denen die Isolationsschicht (20) aufgenommen ist; und
mit einer Innenverkleidung (CI) umfassend einen zweiten plattenförmigen Stützkörper (10') aus einem massiven Schaummaterial, welche an eine zum Gebäudeinneren (I) auszurichtende Oberfläche der Isolationsschicht (20) angrenzt, und mit zweiten Befestigungselementen (40'), welche die Innenverkleidung (CI) durchgreifen, um diese an den Stützelementen (50) zu befestigen, **dadurch gekennzeichnet, dass**
ein erstes wellenförmig ausgebildetes Metalldrahtgitter (30) wenigstens teilweise in eine zum Gebäudeäusseren (E) auszurichtenden Oberfläche des ersten Stützkörpers (10) eingeschäumt ist, wobei die ersten Befestigungsmittel das erste wellenförmig ausgebildetes Metalldrahtgitter (30) durchgreifen, und dass
die Innenverkleidung ein zweites wellenförmig ausgebildetes Metalldrahtgitter (30') umfasst, das teilweise in eine zum Gebäudeinneren (I) auszurichtende Oberfläche des zweiten Stützkörpers (10') eingeschäumt ist,
wobei die Wandstruktur weiter Heiz- und/oder Kühlschläuchen (90) umfasst, die in der Innenverkleidung (CI) verlegt sind und im Wesentlichen zwischen den Wellenbergen des zweiten wellenförmig ausgebildeten Metalldrahtgitters (30') verlaufen, welche über die jeweilige Oberfläche des zweiten Stützkörpers (10') hinausragen, und wobei
die Heiz- und/oder Kühlschläuche (90) zwischen einem jeweils zusätzlichen, sich über die Wellenberge des zweiten wellenförmig ausgebildeten Metalldrahtgitters (30') hinweg erstreckenden, ebenen Metalldrahtgitter und dem zweiten wellenförmig ausgebildeten Metalldrahtgitter (30') gehalten sind.

2. Wandstruktur (W1; W2; W3) nach Anspruch 1, bei dem die Innenverkleidung (CI) eine Innenputzschicht (61) aufweist, die auf der zum Gebäudeinneren (I) auszurichtenden Oberfläche des zweiten Stützkörpers (10') aufgebracht und an dem zweiten Metalldrahtgitter (30') verankert ist.

3. Wandstruktur (W1; W2 ; W3) nach einem der Ansprüche 1 bis 2, mit einer dampfdurchlässigen Folie (70), die sich zwischen der Isolationsschicht (20) und der Innenverkleidung (CI) erstreckt.

4. Wandstruktur (W1; W2; W3) nach einem der vorstehenden Ansprüche, mit einer Aussenverkleidung (CE), die an eine zum Gebäudeäusseren (E) auszurichtende Oberfläche der ersten Stützschicht (10) angrenzt, und die eine Aussenputzschicht umfasst, welche an dem ersten Metalldrahtgitter (30) verankert ist.

5. Wandstruktur (W1; W2 ; W3) nach einem der vorstehenden Ansprüche, mit einem jeweils zusätzlichen dreidimensionalen Metalldrahtgitter (31, 31'), das vollständig in den ersten und/ oder zweiten Stützkörper (10, 10') eingeschäumt ist.

6. Wandstruktur (W1; W2 ; W3) nach einem der vorstehenden Ansprüche, bei dem die Isolationsschicht (20) aus einem Mineralwollmaterial besteht.

7. Wandstruktur (W1; W2; W3) nach einem der vorstehenden Ansprüche, bei dem die ersten und/oder zweiten Befestigungselemente (40, 40') aus einer jeweiligen Schrauben und Widerlagerkombination (41, 42) bestehen, wobei vorzugsweise die jeweilige Schrauben und Widerlagerkombination (41, 42) eine selbstschneidenden Schraube (41') und ein Widerlager (42') aus einem Kunststoffmaterial umfasst.

8. Wandstruktur (W1; W2; W3) nach Anspruch 7, bei welcher der Kopfdurchmesser einer jeweiligen Schraube (41) grösser als die Maschenweite des ersten bzw. zweiten Metalldrahtgitters (30, 30') sind oder bei welcher für eine jeweilige Schraube (41) eine Unterlegscheibe (43) vorgesehen ist, deren Durchmesser grösser als die Maschenweite des ersten bzw. zweiten Metalldrahtgitters (30, 30') ist.

9. Wandstruktur (W1; W2; W3) nach Anspruch 7 bis 8, bei welcher der Kopf einer jeweiligen Schraube (41) mit einer Kunststoffkappe (44) abdeckbar ist und/oder die Unterlegscheibe (43) aus einem Kunststoff besteht.

10. Wandstruktur (W 1; W2 ; W3) nach einem der Ansprüche 7 bis 9, bei der eine jeweilige Stützelement und Widerlagerkombination (50, 42) so geformt und bemessen ist, dass eine in das Widerlager (42) eingedrehte Schraube (41) nicht mit dem Stützelement (50) in Kontakt tritt und/oder dass beim Eindrehen der Schraube (41) eine Bewegung des Widerlagers (42) gegenüber dem Stützelement (50) blockiert ist.

11. Wandstruktur (W1; W2 ; W3) nach einem der vorstehenden Ansprüche, bei der ein jeweiliges Stützelement (50) eine im Wesentlichen U-förmige Querschnittsform aufweist, deren Schenkel mit Durchtrittsöffnungen zur Aufnahme der Befestigungselemente (40, 40') versehen sind.

12. Wandstruktur (W 1; W2 ; W3) nach einem der vorstehenden Ansprüche, mit elektrischen Leitungen (80), die in der Isolationsschicht (20) verlaufen und von den Stützelementen (50) gehalten sind.

13. Wandstruktur (W1; W2 ; W3) nach einem der vorstehenden Ansprüche, bei welcher die Maschenweite des ersten und/oder des zweiten Metalldrahtgitters (30, 30') zwischen 5 mm und 30 mm liegt, bevorzugt ungefähr 10 mm beträgt.

14. Vorgefertigtes Bauelement mit einer Wandstruktur (W1; W2; W3) nach einem der vorstehenden Ansprüche für ein Gebäude.

15. Gebäude mit vorgefertigten Bauelementen nach Anspruch 14, die so angeordnet und miteinander verbunden sind, dass deren erste und/oder zweite Metalldrahtgitter (30, 30') einen Faradayschen Käfig bilden.

## Claims

1. Wall structure (W1; W2; W3) of a building, said wall structure having a first plate-shaped support body (10) made of a solid foam material, the surface of which to be oriented towards the interior (I) of the building adjoins an insulating layer (20), and first fastening elements (40) which penetrate the first support body (10) in order to fasten support elements (50), between which the insulating layer (20) is accommodated;
and having an interior cover (CI) comprising a second plate-shaped support body (10') made of a solid foam material, which adjoins a surface of the insulating layer (20) to be oriented towards the interior (I) of the building, and having second fastening elements (40'), which penetrate the interior cover (CI) in order to fasten said interior cover to the support elements (50), **characterized in that**
a first wave-shaped metal wire grille (30) is foamed at least partially into a surface of the first support body (10) to be oriented towards the exterior (E) of the building, wherein the first fastening elements penetrate the first wave-shaped metal wire grille (30), and **in that**
the interior cover includes a second wave-shaped metal wire grille (30') which is foamed partially into a surface of the second support body (10') to be oriented towards the interior (I) of the building (I) wherein the wall structure furthermore comprises heating and/or cooling hoses (90) which are laid in the interior cover (CI) and extend substantially between the wave crests of the second wave-shaped metal wire grille (30'), which project beyond the respective surface of the second support body (10'), and wherein
the heating and/or cooling hoses (90) are held between a respectively additional flat metal wire grille, which extends beyond the wave crests of the second wave-shaped metal wire grille (30'), and the second wave-shaped metal wire grille (30').

2. Wall structure (W1; W2; W3) according to Claim 1, where the interior cover (CI) has an interior plaster layer (61) which is applied on the surface of the second support body (10') to be oriented towards the interior (I) of the building and is anchored on the second metal wire grille (30').

3. Wall structure (W1; W2; W3) according to one of Claims 1 to 2, having a vapour permeable film (70) which extends between the insulating layer (20) and the interior cover (CI).

4. Wall structure (W1; W2; W3) according to one of the preceding claims, having an exterior cover (CE) which adjoins a surface of the first support layer (10) to be oriented towards the exterior (E) of the building, and which includes an exterior plaster layer which is anchored on the first metal wire grille (30).

5. Wall structure (W1; W2; W3) according to one of the preceding claims, having a further respective three-dimensional metal wire grille (31, 31') which is foamed entirely into the first and/or second support body (10, 10').

6. Wall structure (W1; W2; W3) according to one of the preceding claims, where the insulating layer (20) consists of a mineral wool material.

7. Wall structure (W1; W2; W3) according to one of the preceding claims, where the first and/or second fastening elements (40, 40') consist of a respective screw and abutment combination (41, 42), wherein preferably the respective screw and abutment combination (41, 42) includes a self-tapping screw (41') and an abutment (42') made of a plastics material.

8. Wall structure (W1; W2; W3) according to Claim 7, where the head diameter of a respective screw (41) is greater than the mesh width of the first or second metal wire grille (30, 30') or where a washer (43), the diameter of which is greater than the mesh width of the first or second metal wire grille (30, 30'), is provided for a respective screw (41).

9. Wall structure (W1; W2; W3) according to Claim 7 to 8, where the head of a respective screw (41) is coverable by a plastics material cap (44) and/or the washer (43) consists of a plastics material.

10. Wall structure (W1; W2; W3) according to one of Claims 7 to 9, where a respective support element and abutment combination (50, 42) is formed and dimensioned such that a screw (41) that is screwed-into the abutment (42) does not contact the support element (50) and/or that when the screw (41) is screwed-in, a movement of the abutment (42) in relation to the support element (50) is blocked.

11. Wall structure (W1; W2; W3) according to one of the preceding claims, where a respective support element (50) has a substantially U-shaped cross sectional form, the legs of which are provided with through-openings for the accommodation of the fastening elements (40, 40').

12. Wall structure (W1; W2; W3) according to one of the preceding claims, having electric lines (80) which extend in the insulating layer (20) and are held by the support elements (50).

13. Wall structure (W1; W2; W3) according to one of the preceding claims, where the mesh width of the first and/or of the second metal wire grille (30, 30') is between 5 mm and 30 mm and is preferably approximately 10 mm.

14. Prefabricated structural element having a wall structure (W1; W2; W3) according to one of the preceding claims for a building.

15. Building having prefabricated structural elements according to Claim 14, which are arranged and connected together such that the first and/or second metal wire grilles (30, 30') thereof form a Faraday cage.

## Revendications

1. Structure de mur (W1; W2; W3) d'un bâtiment, avec un premier corps de soutien en forme de plaque (10) en un matériau cellulaire massif, dont la surface à orienter vers l'intérieur du bâtiment (I) est adjacente à une couche d'isolation (20), et avec des premiers éléments de fixation (40), qui traversent le premier corps de soutien (10), afin de fixer des éléments de soutien (50) entre lesquels la couche d'isolation (20) est placée; et
avec un revêtement intérieur (CI) comprenant un deuxième corps de soutien en forme de plaque (10') en un matériau cellulaire massif, qui est adjacent à une surface de la couche d'isolation (20) à orienter vers l'intérieur du bâtiment (I), et avec des deuxièmes éléments de fixation (40'), qui traversent le revêtement intérieur (CI) afin de fixer celui-ci aux éléments de soutien (50),
**caractérisé en ce que**
un premier treillis de fils métalliques de forme ondulée (30) est au moins en partie noyé dans une surface du premier corps de soutien (10) à orienter vers l'extérieur du bâtiment (E), dans laquelle les premiers moyens de fixation traversent le premier treillis de fils métalliques de forme ondulée (30) et **en ce que**
le revêtement intérieur comprend un deuxième treillis de fils métalliques de forme ondulée (30'), qui est en partie noyé dans une surface du deuxième corps de soutien (10') à orienter vers l'intérieur du bâtiment (I),
dans laquelle la structure de mur comprend en outre des tuyaux de chauffage et/ou de refroidissement (90), qui sont posés dans le revêtement intérieur (CI) et qui s'étendent essentiellement entre les crêtes des ondulations du deuxième treillis de fils métalliques de forme ondulée (30'), qui sortent au-delà de la surface respective du deuxième corps de soutien (10'), et dans laquelle
les tuyaux de chauffage et/ou de refroidissement (90) sont maintenus entre un treillis de fils métalliques plan respectivement supplémentaire, s'étendant par-dessus les crêtes des ondulations du deuxième treillis de fils métalliques de forme ondulée (30'), et le deuxième treillis de fils métalliques de forme ondulée (30').

2. Structure de mur (W1; W2; W3) selon la revendication 1, dans laquelle le revêtement intérieur (CI) présente une couche d'enduit intérieur (61), qui est appliquée sur la surface du deuxième corps de soutien (10') à orienter vers l'intérieur du bâtiment (I) et est ancrée sur le deuxième treillis de fils métalliques (30').

3. Structure de mur (W1; W2; W3) selon l'une quelconque des revendications 1 à 2, avec une feuille (70) perméable à la vapeur, qui s'étend entre la couche d'isolation (20) et le revêtement intérieur (CI).

4. Structure de mur (W1; W2; W3) selon l'une quelconque des revendications précédentes, avec un revêtement extérieur (CE), qui est adjacent à une surface de la première couche de soutien (10) à orienter vers l'extérieur du bâtiment (E), et qui comprend une couche d'enduit extérieur, qui est ancrée sur le premier treillis de fils métalliques (30).

5. Structure de mur (W1; W2; W3) selon l'une quelconque des revendications précédentes, avec un treillis de fils métalliques tridimensionnel (31, 31') respectivement supplémentaire, qui est entièrement noyé dans le premier et/ou le deuxième corps de soutien (10, 10').

6. Structure de mur (W1; W2; W3) selon l'une quelconque des revendications précédentes, dans laquelle la couche d'isolation (20) est constituée d'un matériau de laine minérale.

7. Structure de mur (W1; W2; W3) selon l'une quelconque des revendications précédentes, dans laquelle les premiers et/ou les deuxièmes éléments de fixation (40, 40') se composent respectivement d'une combinaison d'une vis et d'une butée (41, 42), dans laquelle de préférence la combinaison respective d'une vis et d'une butée (41, 42) comprend une vis auto-taraudeuse (41') et une butée (42') en matière plastique.

8. Structure de mur (W1; W2; W3) selon la revendication 7, dans laquelle le diamètre de tête d'une vis respective (41) est plus grand que la largeur de maille du premier ou du deuxième treillis de fils métalliques (30, 30') ou dans laquelle il est prévu, pour une vis respective (41), une rondelle (43) dont le diamètre est plus grand que la largeur de maille du premier ou du deuxième treillis de fils métalliques (30, 30').

9. Structure de mur (W1; W2; W3) selon une revendication 7 à 8, dans laquelle la tête d'une vis respective (41) peut être couverte d'un capuchon en matière plastique (44) et/ou la rondelle (43) se compose d'une matière plastique.

10. Structure de mur (W1; W2; W3) selon l'une quelconque des revendications 7 à 9, dans laquelle une combinaison respective d'un élément de soutien et d'une butée (50, 42) est formée et dimensionnée de telle manière qu'une vis (41) vissée dans la butée (42) ne vienne pas en contact avec l'élément de soutien (50) et/ou que, lors du vissage de la vis (41), un mouvement de la butée (42) par rapport à l'élément de soutien (50) soit bloqué.

11. Structure de mur (W1; W2; W3) selon l'une quelconque des revendications précédentes, dans laquelle un élément de soutien respectif (50) présente une section transversale essentiellement en forme de U, dont les branches sont dotées d'ouvertures de passage destinées à recevoir les éléments de fixation (40, 40').

12. Structure de mur (W1; W2; W3) selon l'une quelconque des revendications précédentes, avec des canalisations électriques (80), qui s'étendent dans la couche d'isolation (20) et sont maintenues par les éléments de soutien (50).

13. Structure de mur (W1; W2; W3) selon l'une quelconque des revendications précédentes, dans laquelle la largeur de maille du premier et/ou du deuxième treillis de fils métalliques (30, 30') se situe entre 5 mm et 30 mm, et vaut de préférence environ 10 mm.

14. Elément de construction préfabriqué avec une structure de mur (W1; W2; W3) selon l'une quelconque des revendications précédentes pour un bâtiment.

15. Bâtiment avec des éléments de construction préfabriqués selon la revendication 14, qui sont disposés et reliés les uns aux autres de telle manière que leurs premiers et/ou leurs deuxièmes treillis de fils métalliques (30, 30') forment une cage de Faraday.
